Europäisches Patentamt

European Patent Office

Office européen des brevets

(19)

(11) Veröffentlichungsnummer: **0 006 494**
**A1**

(12) **EUROPÄISCHE PATENTANMELDUNG**

(21) Anmeldenummer: **79101790.8**

(22) Anmeldetag: **06.06.79**

(51) Int. Cl.³: **G 01 R 31/12,** G 01 R 31/14, G 01 R 31/16

(30) Priorität: **16.06.78 DE 2826528**

(43) Veröffentlichungstag der Anmeldung: **09.01.80**
**Patentblatt 80/1**

(84) Benannte Vertragsstaaten: **CH DE FR GB IT NL**

(71) Anmelder: **SIEMENS AKTIENGESELLSCHAFT Berlin und München, Postfach 261, D-8000 München 22 (DE)**

(72) Erfinder: **Dengler, Jochen Dipl.-Ing., Hofmannstrasse 107, D-8520 Erlangen (DE)**
Erfinder: **Loos, Hermann Dipl.-Phys., Thusneldastrasse 16, D-8500 Nürnberg (DE)**

(54) **Verfahren und Vorrichtung zum berührungslosen Überprüfen der Isolation bewegter isolierter Drähte.**

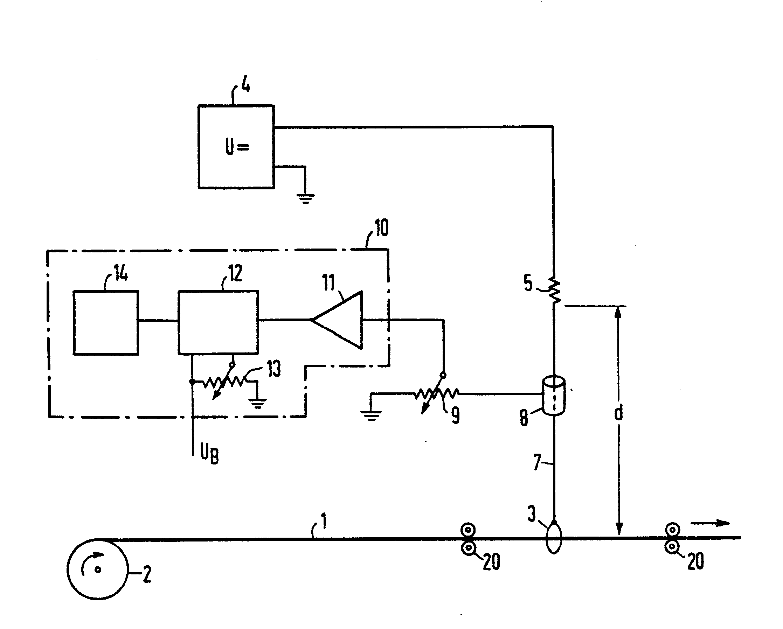

(57) Zum berührungslosen Überprüfen der Isolation beim Ab- oder Aufwickeln isolierter Drähte wird der Draht axial durch eine ringförmige Sonde geführt, die einen Kondensator mit dem Draht als Gegenpol bildet. Die Sonde wird über einen Schutzwiderstand an eine Gleichspannungsquelle angeschlossen. Ein Isolationsfehler ruft einen Durchschlag zwischen Sonde und Draht hervor. An die Sonde ist der eine Pol eines Koppelkondensators angeschlossen, der beim Durchschlag auf das Potential des Drahtes gelegt wird. Dadurch entsteht am anderen Pol des Koppelkondensators ein Spannungsimpuls und ein Verschiebestrom, der erfaßt und angezeigt wird. Schutzwiderstand und Sonde sind auf maximale Ströme von 3 mA ausgelegt (Fig. 1).

BEZEICHNUNG GEÄNDERT
siehe Titelseite

SIEMENS AKTIENGESELLSCHAFT        Unser Zeichen
Berlin und München               VPA 78 P 7 5 1 9 EUR

Berührungsloses Überprüfen der Isolation bewegter
isolierter Drähte

Die Erfindung betrifft ein Verfahren zum berührungslosen Überprüfen der Isolation beim Ab- oder Aufwickeln isolierter Drähte, bei dem der Draht axial
durch eine ringförmige, einen Kondensator mit dem Draht
als Gegenpol bildende Sonde geführt wird, der
Kondensator mittels einer Spannungsquelle derart
aufgeladen wird, daß bei Fehlern in der Drahtisolation
der Kondensator von einem Durchschlagsstrom kurzgeschlossen wird, und das Kurzschließen des Kondensators
angezeigt wird. Die Erfindung betrifft ferner eine
Vorrichtung zur Durchführung des Verfahrens.

An die Isolation von Drähten, insbesondere für Wicklungen elektrischer Maschinen, werden hohe Anforderungen gestellt. So müssen z.B. bei Transformatoren-
oder Motorwicklungen Windungsschlüsse zuverlässig
vermieden werden. Bei der Herstellung der isolierten Drähte wird die Auswahl der Isolation von fertigungstechnischen und elektrischen Gesichtspunkten bestimmt (einfache oder mehrfache Lackisolierung,
Umspinnen mit Glasseide), wobei die Qualität meist
durch Stichproben überprüft wird. Für die Verarbeitung der Drähte werden jedoch häufig höhere
Anforderungen an die Qualität und die Zuverlässigkeit
der Isolierung gestellt. Hierzu werden Verfahren
benötigt, die eine 100%ige Kontrolle der Isolation
des Drahtes erlauben. Diese Kontrolle kann sowohl
bei der Fertigung (Aufwickeln des hergestellten
Drahtes auf Magazinrollen) sowie bei der Verarbeitung
zu Spulen für Transformatoren, Spannungswandler,
Motore, Induktivitäten usw. während des Abwickelns
von der Magazinrolle erfolgen.

Dabei wird nach einem Verfahren gesucht, das hohe
Arbeitsgeschwindigkeiten, also hohe Wickelgeschwindigkeiten beim Ab- oder Aufwickeln, ermöglicht. Die
Kontrolle soll möglichst berührungslos erfolgen,
da beim Berühren des Drahtes mit Kontakten die
Kontakte sehr leicht verschmutzen und häufig gewartet werden müssen. Eine zusätzliche Drahtumlenkung
soll vermieden werden, um Beschädigungen der Isolation
durch den Prüfvorgang selbst auszuschließen. Ferner
sollen auch Haarrisse erfaßt werden. Die Auflösung
des Verfahrens soll hoch sein, d.h. auch noch
verhältnismäßig dicht nebeneinanderliegende Fehlstellen der Isolation sollen als getrennte Fehler
erfaßbar sein. Das Verfahren muß ferner störsicher
sein, um auch noch in Umgebungen mit hohen elektrischem Störpegel eingesetzt werden zu können.
Auch sollen Drähte verschiedener Querschnitte, z.B.
auch rechteckige Drähte, überprüfbar sein, ohne
die Prüfvorrichtung erheblich umrüsten zu müssen.

0006494

- 3 -    VPA 78 P 7519 EUR

Vor allem muß das Verfahren in einer Weise sicher sein, daß für das Betriebspersonal und das Produkt bei versehentlicher Berührung der Prüfvorrichtung kein Schaden entsteht. Dies bedeutet vor allem, daß die Prüfspannungen nicht zu hoch gewählt und die im Kurzschlußfall fließenden Ströme begrenzt werden.

Eine Möglichkeit zum berührungslosen Überprüfen der Isolation bewegter Drähte besteht darin, daß der Draht axial durch eine zylindrische Sonde geführt wird, wobei der Draht den einen Pol, die Sonde den anderen Pol eines Kondensators bildet. Der Kondensator wird aufgeladen, indem der eine Pol einer Spannungsquelle mit der Zylindersonde, der andere Pol der Spannungsquelle geerdet wird. Ein Drahtende wird ebenfalls geerdet. Bei einem Fehler in der Isolation des Drahtes schlägt der Kondensator durch und wird entladen. Von der Spannungsquelle fließt sodann Ladung in den entladenen Kondensator nach, was durch eine entsprechende Anzeigevorrichtung als Fehlermeldung angezeigt wird.

Bei diesem Verfahren liefert die Spannungsquelle eine Wechselspannung. Zu einem Durchschlag kommt es nur, wenn die Wechselspannung etwa ihre maximalen Werte angenommen hat. Punktförmige Fehlstellen müssen deshalb eine halbe Periode in der Sonde verweilen, um erkannt zu werden. Dies bedeutet, daß einerseits die Abzugsgeschwindigkeit des Drahtes beschränkt ist, andererseits entweder sehr lange Sonden oder sehr hohe Frequenzen verwendet werden müssen. Versuche zeigen, daß etwa 6 kV Spitzenspannung für die Wechselspannung nötig sind, um auch kleine Fehlstellen erkennen zu können. Zylindersonden besitzen jedoch eine hohe Streukapazität gegenüber der Erde. Die bei der Prüfung auftretenden Ströme hängen neben der Sondenlänge auch noch von der Leckkapazität der Sonden gegen Erde sowie der Kapazität der Zuleitungen ab. Dies bedeutet, daß erhebliche Prüfströme fließen, die bei optimaler Abstimmung der Prüfapparatur zwischen 3,8 mA (bei 50 Hz) und 3,00 mA (bei 1000 Hz) liegen können. Die im Durchschlagsfall und im Fall einer unsachgemäßen Berührung der Apparatur fließenden Ströme können zwar durch einen Schutzwiderstand zwischen der Spannungsquelle und der Sonde beschränkt werden. Versuche zeigen jedoch, daß bei einer Quellspannung von 6 kV Durchschläge nur zuverlässig erzielt werden, wenn der Schutzwiderstand 20 k$\Omega$ nicht überschreitet. Es ergeben sich dann immer noch Ströme über 300 mA, die lebensgefährlich sind und außerdem das Produkt schädigen können. Es ist daher nötig, die Ströme auf die Werte zu beschränken, bei denen noch eine Prüfung möglich ist, z.B. 4 mA. Derartige Hochspannungsquellen mit Strombegrenzung sind jedoch sehr aufwendig.

Der Erfindung liegt die Aufgabe zugrunde, ein Verfahren zum berührungslosen Überprüfen der Isolation im Hinblick auf die genannten Anforderungen derart zu verbessern, daß insbesondere mit kleiner Strombelastung und somit ohne Gefahren für das Bedienungspersonal gearbeitet werden kann.

Diese Aufgabe wird gemäß der Erfindung dadurch gelöst, daß bei einem Verfahren der eingangs angegebenen Art eine Gleichspannung von der Spannungsquelle über einen Schutzwiderstand an die Sonde und an einen mit einem Pol mit der Sonde verbundenen Koppelkondensator gelegt wird, daß Spannungsquelle und Schutzwiderstand auf einen maximalen Stromfluß von höchstens 3 mA, vorzugsweise etwa 100 $\mu$A, abgestimmt wird und daß das Umladen des Koppelkondensators beim Durchschlag erfaßt wird.

Hierbei läuft folgender Vorgang ab: Zunächst liegen die Sonde und der damit verbundene Teil des Koppelkondensators auf dem Potential der Spannungsquelle. Der von einem Isolationsfehler hervorgerufene Stromdurchschlag entlädt diese Teile innerhalb weniger ns und legt sie auf niedrige Spannung. Dabei kommt es zu Spannungsänderungen und einem Verschiebungsstrom am Koppelkondensator, der dadurch umgeladen wird. Die Sonde wird von der Spannungsquelle wegen des hohen Schutzwiderstandes nur langsam nachgeladen. Während dieser Zeit tritt somit eine deutliche Spannungsänderung am anderen Pol des Koppelkondensators auf, die erfaßt werden kann. Vorteilhaft ist dieser andere Pol über einen Meßwiderstand geerdet, an dem der bei dem Umladen entstehende Verschiebestrom registriert wird, z.B. als Spannungsabfall. Der Meßwiderstand ist dabei vorteilhaft wesentlich kleiner als der Schutzwiderstand, aber doch so groß, daß während der Ansprechzeit einer angeschlossenen Detektoreinrichtung ein über dem Detektor-Schwellwert liegender Spannungsimpuls aufrechterhalten wird.

Vorteilhaft umgibt ein kurzes Rohrstück ringförmig die vom Schutzwiderstand zur Sonde führende Sondenanschlußleitung, die entsprechend der verwendeten Hochspannung isoliert ist, Rohrstück und Sondenanschlußleitung bilden den Koppelkondensator. Die Sondenanschlußleitung wird bevorzugt sehr kurz gehalten, um die sich beim Durchschlag entladende Kapazität und somit die durchschlagende Ladung klein zu halten.

Dabei hat es sich gezeigt, daß der Draht vorteilhaft gegenüber der Sonde elektrisch frei schwebend gehalten werden kann. Der eine Pol der Gleichspannungsquelle kann also geerdet werden (aus Sicherheitsgründen über eine niederohmige Schutzleitung), während der Draht mit seinem an der schnell rotierenden Magazintrommel befestigten Ende nicht geerdet werden muß, wodurch sich der Aufwand erheblich verringert und praktisch keine störenden Induktivitäten vom Drahtmagazin auftreten.

Die Detektoreinrichtung legt (zusammen mit den Meßleitungen) eine gewisse Mindestdauer (Ansprechzeit) fest, während der eine Fehlstelle der Isolation sich in der Sonde befinden muß, um noch zu einem Durchschlag und einer Anzeige zu führen. Durch eine entsprechend schnell arbeitende Elektronik und mit Wellenwiderstand abgeglichene Meßleitungen kann diese Zeit auf etwa 0,8 $\mu$s festgelegt werden. Dadurch ergibt sich, daß die Längsausdehnung der Sonde in Drahtrichtung bei Abzugsgeschwindigkeiten zwischen 15 und 20 m/s nur 12 bis 16 $\mu$m betragen müssen. Es sind also sehr kleine Sonden möglich, vorzugsweise lediglich Drahtschleifen. Wählt man die Sondenlänge etwas größer, so können auch noch kleinste Isolationsfehler, z.B. transversale Haarrisse in der Lackisolierung erkannt werden.

Derartige Sonden besitzen bei kurzen Anschlußleitungen eine sehr geringe Kapazität gegen Erde bzw. Draht (Streu- oder Leckkapazität). Beim Ent- und Nachladen der Sonde fließen daher nur geringe Prüfströme. Man kann Kapazitäten erreichen, die zwischen 2 und 20 mF liegen. Vorteilhaft sind Kapazitäten zwischen 2 und 5 mF.

Während bei Verwendung einer Wechselspannung die Kapazität der Sonde ständig umgeladen werden muß, ist dies beim Verfahren nach der Erfindung nicht nötig. Es kann daher ein sehr großer Schutzwiderstand zwischen der Spannungsquelle und der Meßsonde verwendet werden. Dieser Schutzwiderstand wird so bemessen, daß der Stromfluß 3 mA nicht überschreitet. Vorzugsweise wird er auf 250 µA begrenzt. Diese Ströme sind ungefährlich. Die Dimensionierung des Schutzwiderstandes ergibt sich dabei entsprechend der verwendeten Gleichspannung. Vorteilhaft werden Gleichspannungen zwischen 6 und 10 kV verwendet.

Das Auflösungsvermögen der Anordnung ergibt sich aus der Totzeit, innerhalb derer nach Auftreten eines Fehlers kein weiterer Fehler erkannt werden kann. Diese Totzeit ist bedingt durch das erneute Aufladen der Leckkapazität der Anordnung gegen Erde und ist durch die Sondenkapazität und den Schutzwiderstand vorgegeben. Entsprechend der Abzugsgeschwindigkeit entspricht dieser Totzeit eine Totzeitlänge. Diese Länge ist der Mindestabstand zweier getrennt erkennbarer Fehler (Auflösungsvermögen). Er wird möglichst klein gewählt, jedoch noch groß genug, damit sich während der Totzeit ein einmal erkannter Fehler so weit von der Sonde entfernt, daß zwischen der Sonde und dem erkannten Isolationsfehler kein Funken mehr gezogen wird.

Die zum Aufladen des Kondensators von der Spannungsquelle abgegebenen, auf kleine Werte begrenzten Ströme können an der Hochspannungsquelle, die aus Sicherheitsgründen niederohmig geerdet sein muß, nicht am geerdeten Pol erfaßt werden. Eine die Ströme dort abgreifende Detektoreinrichtung würde ferner große Erdschleifen bewirken. Auch ist eine Ausbreitung der sehr kurzzeitigen Stromimpulse durch die von der Sonde zur Hochspannungsquelle und zur Erde führenden Leitungen nicht möglich, falls diese Leitungen nicht mit Wellenwiderstand abgeschlossen sind. Gemäß der Erfindung werden die Ströme auf hohem Potential zwischen dem Schutzwiderstand und der Sonde erfaßt, wo die vom Durchschlag erzeugten Spannungsänderungen bzw. Stromstöße am ausgeprägtesten und selbst bei hohem elektrischen Störpegel eindeutig erkennbar sind. Die Kapazität des verwendeten Koppelkondensators wird klein gewählt, insbesondere zu 4 bis 5 pF.

Anhand einer Figur und eines Ausführungsbeispieles wird die Erfindung näher erläutert.

In der Figur ist mit 1 der isolierte Draht bezeichnet, der in Pfeilrichtung von einer Magazinrolle 2 mit hohen Geschwindigkeiten abgezogen und über Rollen 20 geführt wird. Der Draht 1 ist axial durch eine ringförmige Sonde geführt, die als Drahtschleife 3 ausgebildet ist. Draht 1 und Sonde 3 bilden einen Kondensator. Eine Gleichspannungsquelle 4, die eine zwischen 0 und 6 kV regelbare Spannung $U_\sim$ liefert, ist mit einem Ausgang geerdet, mit dem anderen Ausgang über einen Schutzwiderstand 5 an die Sonde 3 angeschlossen. Der Kondensator wird dadurch aufgeladen. Eine Erdung des Drahtes 1, z.B. über sein an der Magazinrolle 2 befestigtes Ende, ist nicht erforderlich, da sich Ladungen, die bei Isolationsfehlern von der Sonde 3 auf den Draht 1 übergehen, nur begrenzt in dem Draht, der eine hohe Kapazität darstellt, ausbreiten, wie die Erfahrung zeigt.

Bei einem Durchschlag wird der Kondensator entladen und es fließen Ladungen aus der Spannungsquelle 4 nach. Die Stärke des dabei auftretenden Stromes (Prüfstrom) wird durch den Schutzkondensator 5 beschränkt, der dadurch gleichzeitig auch die bei Kurzschlüssen oder bei Berührung der Sonde durch das Bedienungspersonal auftretenden Ströme begrenzt. Der Schutzwiderstand 5 ist dabei mit 25 M$\Omega$ derart auf die Spannungsquelle 4 abgestimmt, daß auch im Kurzschlußfall nur 240 /uA fließt.

Nach einem durch einen Isolationsfehler erzeugten Durchschlag wird die Sonde 3 erneut aufgeladen, wozu eine Totzeit benötigt wird, innerhalb derer es zu keinem weiteren Durchschlag kommen kann. Diese Totzeit ist durch die Leckkapazität des Kondensators und die Größe des Schutzwiderstandes bestimmt. Tritt ein Durchschlag auf, falls die tatsächlich an der Sonde anliegende Prüfspannung 99 % der Quellspannung der Spannungsquelle überschreitet, so beträgt die Totzeit etwa 2,3 m/s. Dies entspricht bei einer Abzugsgeschwindigkeit von 15 m/s einer Strecke von 3,4 cm, um die sich der Fehler von der Sonde entfernt hat. Diese Entfernung ist so groß, daß dann kein Funken zwischen dem Isolationsfehler und der Sonde gezogen wird, der Fehler also mit Sicherheit nicht doppelt registriert wird. Die Totzeitlänge entspricht dem minimalen Abstand zweier noch getrennt erfaßbarer Fehler und bestimmt somit das Auflösungsvermögen. Durch Verkleinerung des Schutzwiderstandes kann die Totzeitlänge verkleinert, also das Auflösungsvermögen verbessert werden, wobei man jedoch aus Sicherheitsgründen den Schutzwiderstand nicht soweit herabsetzen darf, daß der maximal auftretende Strom 3 mA überschreitet. In diesem Fall ist bei 6 kV Quellspannung der Schutzwiderstand auf 2 M$\Omega$ bemessen, die Totzeit beträgt dann 0,18 m/s und das Auflösungsvermögen etwa 2,8 mm. Auch in diesem Falle entstehen keine Funken, allerdings kann eine Fehlstelle zweimal erfaßt werden. Dies kann jedoch durch eine geschickte Auswertung, z.B. eine Antikoinzidenzschaltung in der Detektoreinrichtung, vermieden werden.

Der bei einem Durchschlag und dem anschließenden Nachladen der Sonde entstehende Spannungshub liegt zwischen dem Schutzwiderstand 5 und der Sonde 3 in unverminderter Höhe an, wobei die Länge d zwischen dem Schutzwiderstand und der Sonde kurz bemessen ist, z.B. unter 60 cm, z.B. 5 cm. An diesem Sondenanschluß wird der Spannungshub abgegriffen, wozu ein kurzes, die Sondenanschlußleitung ringförmig umschließendes Rohrstück 8 vorgesehen ist. Das Rohrstück 8 bildet somit die eine Seite eines Koppelkondensators, die über einen Widerstand 9 geerdet ist. Die Kapazität des Koppelkondensators und die Größe des Widerstandes sind so aufeinander abgestimmt, daß der Ladungszustand des Koppelkondensators nach einem Durchschlag rasch wieder hergestellt wird, um eine erneute Fehlererfassung zu ermöglichen. Nach einem Durchschlag entsteht am Widerstand 9 ein Spannungsimpuls, der abgegriffen und in der Meßeinrichtung 10 verarbeitet wird. Dieser Spannungsimpuls muß während der Ansprechzeit der Meßeinrichtung, also den obenerwähnten 0,8 /us, größer sein als ein Schwellwert für das Ansprechen der Anzeigeeinrichtung. Wird dieser Schwellwert auf 75 % des Maximalwertes des Spannungsimpulses eingestellt, so kann man 5 pF für die Kapazität des Koppelkondensators und 560 k$\Omega$ für den Widerstand R wählen.

Zur Verarbeitung des am Widerstand 9 anliegenden Spannungshubes dient ein Detektor 10, dessen Eingang zunächst einen Verstärker 11 als Impedanzwandler enthält. Daran schließt sich ein Komparator 12 an, in dem die vom Verstärker 11 kommende Spannung mit einer an einem Potentiometer 13 abgreifbaren, vorgebbaren Spannung als Schwellwert verglichen wird. Bei Überschreiten des Spannungsimpulses wird vom Komparator ein Signal in einen Signalgeber 14 gegeben, der die Fehlermeldung anzeigt. Dies kann z.B. durch Ansprechen eines optischen oder akkustischen Signals geschehen, es kann aber auch gleichzeitig ein Signal zum Abschalten der Abzugsvorrichtung des Drahtes gegeben werden. Vorteilhaft ist es, wenn die auftretenden Fehler gezählt werden, um ein Maß für die Qualität der Drahtisolation zu erhalten, und wenn der Ablauf beim Verarbeiten des Drahtes nur dann unterbrochen wird, wenn mehrere Fehler kurz hintereinander auftreten. Einige, im größerem Abstand auftretenden Isolationsfehler können nämlich in vielen Fällen toleriert werden, z.B. bei Wicklungen, wo entfernt liegende Schwachstellen der Isolation noch nicht zu Windungsschlüssen führen.

Ist der Detektor aus handelsüblichen Elektronik-Bauteilen zusammengesetzt, die mit einer Versorgungsspannung $U_B$ von 15 V arbeiten, so müssen die entstehenden hohen Spannungshübe beim Abgreifen am
Widerstand abgeschwächt werden. Dieser Widerstand
ist daher als Spannungsteiler (Potentiometer)
ausgebildet.

Das Verfahren ermöglicht das Erkennen von kleinen
und kleinsten Fehlstellen in isolierten Drähten. Es
arbeitet berührungslos und mit kleinen Strombelastungen,
die weder für das Bedienungspersonal noch für die
Drahtisolation selber gefährlich sind. Es ist insbesondere für höchste Abzugsgeschwindigkeiten (Drahtgeschwindigkeiten über 15 m/s) geeignet und erkennt
auch Haarrisse in der Isolation unabhängig von der
Anzahl der aufgebrachten Windungen beim Wickeln
von Spulen. Trotz der hohen Prüfschärfe liegt der
Preis des Verfahrens nur unwesentlich über dem Preis
anderer Verfahren, die eine derart hohe Auflösung
nicht gewährleisten und nur durch gewissenhafte
Wartung der Meßeinrichtung möglich sind. Ferner
ist es möglich, während der Verarbeitung der Drähte
ein Meßprotokoll über die Qualität des Produktes
herzustellen.

10 Patentansprüche
1 Figur

0006494

Patentansprüche

1. Verfahren zum berührungslosen Überprüfen der Isolation bei Ab- oder Aufwickeln isolierter Drähte, bei dem der Draht axial durch eine ringförmige, einen Kondensator mit dem Draht als Gegenpol bildende Sonde geführt wird, der Kondensator mittels einer Spannungsquelle derart aufgeladen wird, daß bei Fehlern in der Drahtisolation der Kondensator von einem Durchschlagsstrom kurzgeschlossen wird, und das Kurzschließen des Kondensators angezeigt wird, d a d u r c h  g e k e n n z e i c h n e t , daß von der Spannungsquelle (4) über einen Schutzwiderstand (5) eine Gleichspannung an die Sonde (3) und einen mit der Sonde verbundenen Koppelkondensator (8) gelegt wird, daß Spannungsquelle und Schutzwiderstand auf einen maximalen Stromfluß von 3 mA, vorzugsweise 250 µA, ausgelegt werden und das Umladen des Koppelkondensators (8) beim Durchschlag erfaßt wird.

2. Verfahren nach Anspruch 1, d a d u r c h  g e k e n n z e i c h n e t , daß als Koppelkondensator ein die Sondenanschlußleitung (7) ringförmig umgebendes Rohrstück verwendet wird.

3. Verfahren nach Anspruch 2, d a d u r c h  g e k e n n z e i c h n e t , daß der Draht (1) gegenüber der Sonde (3) elektrisch frei schwebend gehalten wird.

4. Vorrichtung zur Durchführung des Verfahrens nach einem der Ansprüche 1 bis 3, d a d u r c h  g e k e n n z e i c h n e t , daß eine Führung (20) für den isolierten Draht und eine den Draht (1) ring-

0006494

förmig umgebende Sonde (3) vorgesehen sind, daß die
Sonde über einen Schutzwiderstand (5) an den einen
Pol einer Gleichspannungsquelle (4) angeschlossen
ist, daß Spannungsquelle und Schutzwiderstand derart
ausgelegt sind, daß der maximal auftretende Stromfluß
auf 3 mA beschränkt ist, und daß die Sondenanschlußleitung (7) zwischen Sonde und Schutzwiderstand
kapazitiv          mit einer Detektoreinrichtung
(10) gekoppelt ist.

5. Vorrichtung nach Anspruch 4,  d a d u r c h
g e k e n n z e i c h n e t ,  daß zur kapazitiven
Kopplung  ein die Sondenanschlußleitung
(7) ringförmig umgebendes Rohrstück (8) vorgesehen
ist.

6. Vorrichtung nach Anspruch 4 oder 5,  g e k e n n -
z e i c h n e t  durch eine Drahtschleife (3) als
Sonde.

7. Vorrichtung nach einem der Ansprüche 4 bis 6,
d a d u r c h  g e k e n n z e i c h n e t ,  daß
die Streukapazität der Sonde und der Sondenanschlußleitung zwischen 2 und 20 pF beträgt.

8. Vorrichtung nach Anspruch 7,  d a d u r c h
g e k e n n z e i c h n e t ,  daß die Streukapazität
der Sonde 2 bis 4 pF beträgt.

9. Vorrichtung nach Anspruch 7 oder 8,  d a d u r c h
g e k e n n z e i c h n e t ,  daß die Kapazität
des Koppelkondensators etwa 4 bis 5 pF beträgt.

10. Vorrichtung nach einem der Ansprüche 4 bis 9,
d a d u r c h   g e k e n n z e i c h n e t ,   daß
die Spannung der Spannungsquelle etwa 6 bis 10 kV
beträgt.

Europäisches
Patentamt

**EUROPÄISCHER RECHERCHENBERICHT**

0006494

Nummer der Anmeldung

EP 7910179o.8

| | EINSCHLÄGIGE DOKUMENTE | | KLASSIFIKATION DER ANMELDUNG (Int.Cl.³) |
|---|---|---|---|
| Kategorie | Kennzeichnung des Dokuments mit Angabe, soweit erforderlich, der maßgeblichen Teile | betrifft Anspruch | G o1 R 31/12 |
| X | AT-B   281 191 (VEB Elektromat)  + Zeichnung; Seite 2, Zeilen 31, 36 und 41 + | | G o1 R 31/14 G o1 R 31/16 |

**RECHERCHIERTE SACHGEBIETE (Int. Cl.²)**

G o1 R 31/12

G o1 R 31/14

G o1 R 31/16

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patent-familie,   übereinstimmendes Dokument

Der vorliegende Recherchenbericht wurde für alle Patentansprüche erstellt.

| Recherchenort WIEN | Abschlußdatum der Recherche 24.Juli 1979 | Prüfer KUNZE |
|---|---|---|

EPA form 1503.1   06.78